# EUROPÄISCHE PATENTSCHRIFT

(11) **EP 2 059 837 B1**
(45) Veröffentlichungstag und Bekanntmachung des Hinweises auf die Patenterteilung: **17.04.2019**
(21) Anmeldenummer: 07817435.6
(22) Anmeldetag: 22.08.2007
(51) Int. Cl.: G02B 5/28, H01S 5/068, H01S 5/183, H01S 5/14, H01S 5/40, H01S 5/06, H01S 5/04, H01S 5/022, H01S 5/00, H01S 3/109

(54) **OPTOELEKTRONISCHE HALBLEITERVORRICHTUNG**
OPTO-ELECTRONIC SEMICONDUCTOR APPARATUS
DISPOSITIF À SEMI-CONDUCTEUR OPTOÉLECTRONIQUE

(30) Priorität: 08.09.2006 DE 102006042195
(43) Veröffentlichungstag der Anmeldung: 20.05.2009
(73) Patentinhaber: OSRAM Opto Semiconductors GmbH, 93055 Regensburg (DE)
(72) Erfinder: SCHWARZ, Thomas, 93055 Regensburg (DE); STEEGMÜLLER, Ulrich, Northville, MI 48167 (US); KÜHNELT, Michael, 93051 Regensburg (DE)
(74) Vertreter: Epping - Hermann - Fischer
(86) Internationale Anmeldenummer: PCT/DE2007/001503
(87) Internationale Veröffentlichungsnummer: WO 2008/028454

(56) Entgegenhaltungen:
- WO-A1-2006/012819
- DE-A1- 10 043 896
- GB-A- 2 203 892
- JP-A- H11 163 441
- JP-A- 2002 321 937
- US-A- 5 949 804
- US-A1- 2004 228 375
- US-A1- 2006 023 173
- US-B1- 6 349 156
- CASEL O ET AL: "Blue 489-nm picosecond pulses generated by intracavity frequency doubling in a passively mode-locked optically pumped semiconductor disk laser" APPLIED PHYSICS B ; LASERS AND OPTICS, SPRINGER-VERLAG, BE, Bd. 81, Nr. 4, 1. August 2005 (2005-08-01), Seiten 443-446, XP019337509 ISSN: 1432-0649
- JACQUEMET ET AL.: "Single-Frequency High-Power Continuous-Wave Oscillation at 1003 nm of an Optically Pumped Semiconductor Laser" PROC SPIE INT. SOC. OPT. ENG.; CONFERENCE ON SEMICONDUCTOR LASERS AND LASER DYNAMICS II, APR. 3 - 6, 2006, STRASBOURG, FRANCE, Bd. 6184, April 2006 (2006-04), XP002465420
- JACQUEMET M ET AL: "Single-frequency cw vertical external cavity surface emitting semiconductor laser at 1003 nm and 501 nm by intracavity frequency doubling" APPLIED PHYSICS B ; LASERS AND OPTICS, SPRINGER-VERLAG, BE, Bd. 86, Nr. 3, 30. November 2006 (2006-11-30), Seiten 503-510, XP002465421 ISSN: 1432-0649

## Beschreibung

Es wird eine optoelektronische Halbleitervorrichtung mit einem Etalon angegeben.

Die Druckschrift EP 1 125 350 A1 beschreibt eine optoelektronische Halbleitervorrichtung.

Die Druckschrift JP 11-163441 A beschreibt eine optoelektronische Halbleitervorrichtung.

Die Druckschrift WO 2006/012819 beschreibt eine optoelektronische Halbleitervorrichtung nach dem Oberbegriff des Patentanspruch 1.

Eine zu lösende Aufgabe besteht darin, eine Halbleitervorrichtung mit einem kostengünstig herstellbaren Etalon anzugeben.

Die Aufgabe wird durch eine optoelektronische Halbleitervorrichtung gemäß Anspruch 1 gelöst.

Eine erfindungsgemäße Halbleitervorrichtung ist spezifiziert durch die Merkmale des Anspruchs 1.

Im Folgenden werden Teile der Beschreibung und Zeichnungen, die sich auf Ausführungsformen und Ausführungsbeispiele beziehen, die nicht von den Ansprüchen abgedeckt sind, nicht als Ausführungsformen und Ausführungsbeispiele der Erfindung präsentiert, sondern als Beispiele, die zum Verständnis der Erfindung nützlich sind.

Gemäß zumindest einer Ausführungsform ist das Etalon als frequenzselektives Element im Resonator der optoelektronischen Halbleitervorrichtung vorgesehen. Bei der optoelektronischen Halbleitervorrichtung handelt es sich zum Beispiel um eine Halbleitervorrichtung mit einem oberflächenemittierenden Halbleiterchip - insbesondere einem oberflächenemittierenden Halbleiterlaserchip. Bei der Halbleitervorrichtung handelt es sich dann um eine Halbleiterlaservorrichtung.

Bei einer solchen optoelektronischen Halbleitervorrichtung kann es zu Veränderungen und/oder Verschiebungen der Wellenlänge der im Resonator umlaufenden elektromagnetischen Strahlung kommen, die beispielsweise auf eine Temperaturänderung des optoelektronischen Halbleiterchips zurückzuführen sind. Das Etalon ist im Resonator der Halbleitervorrichtung als frequenzselektives Element vorgesehen, das Wellenlängen innerhalb einer bestimmten Bandbreite transmittiert und Wellenlängen außerhalb dieser Bandbreite abschwächt. Das Etalon ist dadurch geeignet, die Halbleitervorrichtung auf eine bestimmte Wellenlänge oder einen bestimmten Wellenlängenbereich innerhalb der Bandbreite zu zwingen. Eine Veränderung und/oder Verschiebung der Wellenlänge wird dadurch verhindert oder zumindest reduziert.

Das Etalon umfasst eine Etalon-Schicht. Die Etalon-Schicht ist auf einem Träger aufgebracht und mit dem Träger verbunden. Das heißt, die Etalon-Schicht haftet am Träger. Die Etalon-Schicht bildet den optisch aktiven Teil des Etalons. Das heißt, durch die Etalon-Schicht tritt die elektromagnetische Strahlung, die vom Etalon frequenzselektiert wird.

Gemäß zumindest einer Ausführungsform enthält oder besteht die Etalon-Schicht aus Glas. Diese Materialien erlauben eine besonders kostengünstige und einfache Herstellung der Etalon-Schicht und damit des Etalons. Darüber hinaus erlauben diese Materialien die Herstellung einer besonders dünnen Etalon-Schicht.

Gemäß zumindest einer Ausführungsform ist die Etalon-Schicht als Scheibe oder Platte ausgeführt, die eine bestimmte Dicke aufweist. Die Dicke der Etalon-Schicht beträgt dabei zwischen wenigstens zwei Mikrometer und höchstens fünfzig Mikrometer. Insbesondere die oben aufgeführten Materialien - Glas, Halbleitermaterial - erlauben eine besonders einfache Herstellung einer solch dünnen Etalon-Schicht.

Gemäß zumindest einer Ausführungsform weist das Etalon eine Bandbreite zwischen wenigstens einem halben Nanometer und höchstens fünf Nanometer auf. Innerhalb der Bandbreite beträgt die Transmission des Etalons bevorzugt wenigstens 99 Prozent. Das bedeutet, das Etalon weist einen besonders engen Wellenlängenbereich - die Bandbreite - um eine bestimmte Peakwellenlänge auf. Innerhalb der Bandbreite des Etalons zeichnet sich das Etalon durch eine sehr hohe Transmission aus. Das heißt, elektromagnetische Strahlung mit einer Wellenlänge innerhalb der Bandbreite, die das Etalon durchläuft, wird vom Etalon kaum abgeschwächt. Außerhalb der Bandbreite fällt die Transmission auf unter 90 Prozent ab. Dies gilt bevorzugt für einen Wellenlängenbereich von circa fünf bis zwanzig Nanometer um die Peakwellenlänge.

Gemäß zumindest einer Ausführungsform ist das Etalon als eine Scheibe ausgeführt, deren Durchmesser höchstens 800 Mikrometer beträgt. Bevorzugt beträgt der Durchmesser wenigstens 500 Mikrometer. Die Herstellung eines Etalons mit solch geringen Abmessungen ist insbesondere mit den oben aufgeführten Materialien für die Etalon-Schicht ermöglicht. Ein Etalon mit solch geringen Abmessungen ermöglicht eine weitere Miniaturisierung der Halbleitervorrichtung, in der das Etalon zum Einsatz kommt.

Gemäß zumindest einer Ausführungsform bildet das Substrat, auf das die Etalon-Schicht abgeschieden ist, einen Träger für die Etalon-Schicht. Dazu ist das Substrat bevorzugt stellenweise von der Etalon-Schicht entfernt. Durch das Entfernen des Substrats von der Etalon-Schicht ist eine Öffnung im Substrat gebildet, in der die Etalon-Schicht frei liegt. Durch die Öffnung tritt bei Verwendung des Etalons die elektromagnetische Strahlung, die vom Etalon frequenzselektiert, das heißt, transmittiert oder abgeschwächt, wird.

Gemäß zumindest einer Ausführungsform besteht die Etalon-Schicht aus einem Glas, das auf einen Träger befestigt, insbesondere gebondet, ist. Bei dem Träger handelt es sich um Silizium. Das Glas ist dann vorzugsweise anodisch auf den Träger gebondet oder mittels eines Klebstoffes auf den Träger geklebt.

Gemäß zumindest einer Ausführungsform besteht die Etalon-Schicht aus einem Floatglas. Floatglas ist ein Flachglas, welches in einem Floatprozess oder auch Floatglasverfahren hergestellt wird. Floatglas zeichnet sich durch eine besonders regelmäßige und gleichmäßige Dicke aus. Vorzugsweise beträgt die Dicke der Etalon-Schicht aus Floatglas zwischen 40 und 50 µm, vorzugsweise 30 µm.

Gemäß zumindest einer Ausführungsform besteht die Etalon-Schicht aus einem Glas, das auf einem Träger befestigt ist.

Die Gesamtdicke von Etalon-Schicht und Träger beträgt dabei vorzugsweise mindestens 1 mm und höchstens 1,5 mm.

Gemäß zumindest einer Ausführungsform wird der Träger nach dem Befestigen, insbesondere Bonden, des Glases auf den Träger stellenweise von der Etalon-Schicht entfernt. Dadurch ist zumindest eine Öffnung im Träger erzeugt, in der die Etalon-Schicht frei gelegt ist. Durch die Öffnung tritt bei der Verwendung des Etalons in einer optoelektronischen Halbleitervorrichtung die elektromagnetische Strahlung, die vom Etalon frequenzselektiert - das heißt, transmittiert oder abgeschwächt - wird.

Gemäß zumindest einer Ausführungsform wird die Öffnung im Träger vor dem Befestigen der Etalon-Schicht aus Glas im Träger erzeugt. Durch diese Öffnung tritt bei der Verwendung des Etalons in einer optoelektronischer Halbleitervorrichtung die elektromagnetische Strahlung, die vom Etalon frequenzselektiert - das heißt, transmittiert oder abgeschwächt - wird.

Gemäß zumindest einer Ausführungsform der optoelektronischen Halbleitervorrichtung weist die Halbleitervorrichtung einen oberflächenemittierenden Halbleiterchip auf. Bei dem oberflächenemittierenden Halbleiterchip handelt es sich vorzugsweise um einen Halbleiterlaserchip mit einer ersten reflektierenden Schichtenfolge sowie einer strahlungserzeugenden Schichtenfolge. Bei dem Halbleiterchip kann es sich um einen elektrisch gepumpten oder optisch gepumpten Halbleiterchip handeln.

Gemäß zumindest einer Ausführungsform der optoelektronischen Halbleitervorrichtung umfasst die Halbleitervorrichtung einen ersten und einen zweiten Resonatorspiegel, die einen Resonator für die im Betrieb der Halbleitervorrichtung vom oberflächenemittierenden Halbleiterchip erzeugte elektromagnetische Strahlung bilden. Bei dem ersten Resonatorspiegel handelt es sich vorzugsweise um die reflektierende Schichtenfolge des oberflächenemittierenden Halbleiterchips - beispielsweise eine Bragg-Spiegel. Der zweite Resonatorspiegel ist vorzugsweise durch einen externen das heißt, beabstandet vom Halbleiterchip angeordneten Spiegel gebildet.

Gemäß zumindest einer Ausführungsform der optoelektronischen Halbleitervorrichtung weist die Halbleitervorrichtung einen oberflächenemittierenden Halbleiterchip, einen ersten und einen zweiten Resonatorspiegel, die einen Resonator für die im Betrieb der Halbleitervorrichtung vom oberflächenemittierenden Halbleiterchip erzeugte elektromagnetische Strahlung bilden und ein erstes Etalon nach zumindest einem der vorherigen Ausführungsformen auf, das als frequenzselektives Element für die vom oberflächenemittierenden Halbleiterchip erzeugte elektromagnetische Strahlung im Resonator angeordnet ist.

Der optoelektronischen Halbleitervorrichtung liegt dabei unter anderem die Idee zugrunde, dass ein Etalon als frequenzselektives Element nur sehr geringe Verluste aufweist und darüber hinaus eine aufwändige Justage entfällt, da das Etalon einfach in den Resonator eingebaut werden kann. Die Herstellung des Etalons aus einem Halbleitermaterial oder Glas ermöglicht dabei ein besonders kostengünstiges Etalon und damit auch eine besonders kostengünstige optoelektronische Halbleitervorrichtung. Bei der Verwendung des Etalons im Resonator der optoelektronischen Halbleitervorrichtung kann der Resonator vorteilhaft nur innerhalb der vom Etalon vorgegebenen Bandbreite anschwingen. Der Resonator zeigt keine Verschiebung der Wellenlänge beispielsweise in Abhängigkeit der Temperatur des Halbleiterchips.

Gemäß zumindest einer Ausführungsform der Halbleitervorrichtung bildet das erste Etalon einen Teil des Trägers für den zweiten Resonatorspiegel. Dies ermöglicht eine besonders einfache Herstellung der optoelektronischen Halbleitervorrichtung insbesondere dann, wenn das Etalon eine Etalon-Schicht aus Glas umfasst, das auf einen Träger gebondet ist. Der Träger für die Etalon-Schicht bildet in diesem Fall gleichzeitig den Träger für den Resonatorspiegel.

Gemäß zumindest einer Ausführungsform der optoelektronischen Halbleitervorrichtung ist zumindest ein optisch nichtlinearer Kristall im Resonator der Halbleitervorrichtung angeordnet. Vorzugsweise ist der optisch nicht-lineare Kristall zur Frequenzverdoppelung oder allgemein Frequenzvervielfachung eines Teils der im Resonator umlaufenden Strahlung geeignet.

Bevorzugt umfasst der optisch nicht-lineare Kristall zumindest einen der folgenden Kristalle: Lithiumtriborat z.B. LiB₃O₅ (LBO), Wismuttriborat z.B. BiB₃O₆ (BiBO), Kaliumtitanylphosphat KTiOPO₄ (KTP), magnesiumoxiddotiertes kongruentes Lithiumniobat z.B. MgO:LiNbO₃ (MgO:LN), magnesiumoxiddotiertes stöchiometrisches Lithiumniobat z.B. MgO:s-LiNbO₃ (MgO:SLN), magnesiumoxiddotiertes stöchiometrisches Lithiumtantalat z.B. MgO:LiTaO₃ (MgO:SLT), stöchiometrisches LiNbO₃ (SLN), stöchiometrisches LiTaO₃ (SLT), RTP (RbTiOPO₄), KTA (KTiOAsO₄), RTA (RbTiOAsO₄), CTA (CsTiOAsO₄) .

Es wird weiter ein Verfahren zur Herstellung eines Etalons angegeben. Gemäß zumindest einer Ausführungsform des Verfahrens zur Herstellung eines Etalons weist das Verfahren die folgenden Verfahrensschritte auf: Zunächst wird ein Aufwachssubstrat bereitgestellt. Bei dem Aufwachssubstrat handelt es sich zum Beispiel um ein Substrat das eines der folgenden Materialien enthält oder aus einem der folgenden Materialien besteht: GaAs, GaP, InP.

In einem folgenden Verfahrensschritt wird eine Ätzstoppschicht, die beispielsweise GaInP enthalten kann, auf das Substrat abgeschieden. Die Dicke der Ätzstoppschicht beträgt dabei vorzugsweise zwischen fünf und 50 Nanometer. In einem nachfolgenden Verfahrensschritt wird auf die Ätzstoppschicht die Etalon-Schicht in der gewünschten Dicke abgeschieden. Die Dicke der Etalon-Schicht beträgt vorzugsweise zwischen wenigstens zwei bis höchstens 50 Mikrometer.

In einem weiteren Verfahrensschritt wird das Aufwachssubstrat stellenweise von der Etalon-Schicht entfernt. Das Substrat kann beispielsweise mittels einer Fototechnik strukturiert und bis zur Ätzstoppschicht geätzt werden.

Auf diese Weise können mehrere tausend Etalons auf einem einzigen Aufwachssubstrat - beispielsweise einem 100 Millimeter Wafer - hergestellt werden. Die Anordnung aus Aufwachssubstrat und Etalon-Schicht wird in einem abschließenden Verfahrensschritt zu einzelnen Etalon-Chips vereinzelt. Die typische Chipgröße beträgt dabei bevorzugt höchstens 1,5 x 1,5 Millimeter, besonders bevorzugt höchstens 1,0 x 1,0 Millimeter.

Gemäß zumindest einer Ausführungsform des Verfahrens zur Herstellung des Etalons weist das Verfahren die folgenden Verfahrensschritte auf: Zunächst wird eine Glasscheibe auf einen Träger gebondet. Beispielsweise handelt es sich bei dem Träger um einen Siliziumträger. Die Glasscheibe wird dann anodisch auf den Siliziumträger gebondet.

In einem nächsten Verfahrensschritt wird die Glasscheibe auf die gewünschte Dicke der herzustellenden Etalon-Schicht gedünnt. Das Dünnen kann beispielsweise mittels eines Schleif- und Polierprozesses erfolgen.

In einem nächsten Verfahrensschritt wird der Träger zumindest stellenweise von der Glasscheibe entfernt. Dies kann beispielsweise durch eine Strukturierung des Trägers mittels Fototechnik und anschließendes Ätzen von Öffnungen in den Trägern erfolgen.

Gemäß zumindest einer Ausführungsform des Verfahrens ist es auch möglich, dass die Öffnungen vor dem Bonden in den Träger strukturiert werden. Dies kann beispielsweise durch Schleifen oder Ätzen geschehen.

Gemäß zumindest einer Ausführungsform des Verfahrens zur Herstellung eines Etalons weist das Verfahren die folgenden Schritte auf. Zunächst wird eine freitragende Glasscheibe hergestellt, die eine Dicke zwischen 20 und 40 Mikrometer aufweist. Die Herstellung einer solchen Glasscheibe ist beispielsweise durch Schleif- und Polierprozesse möglich. Die Dickeschwankungen innerhalb der Glasscheibe liegen bei circa plus/minus fünf Mikrometer oder weniger. Dickeschwankungen von plus/minus 0,1 Mikrometer sind innerhalb der Glasscheibe in Bereichen einer Größe zwischen kleiner einem Quadratmillimeter oder mehreren Quadratmillimetern vorhanden. Durch eine Transmissionsmessung an der Glasscheibe mit der gewünschten Wellenlänge - das heißt der Peakwellenlänge, die das herzustellende Etalon transmittieren soll - lässt sich eine "Landkarte" mit geeigneten Bereichen auf der Glasscheibe erstellen. Diese geeigneten Bereiche sind zur Verwendung als Etalon geeignet. Die Glasscheibe wird in diesen Bereichen in einzelne Etalon-Chips vereinzelt, beispielsweise zersägt.

Alternativ zu diesem verfahren kann auf die Glasscheibe in einer Beschichtungsanlage eine weitere, transparente dünne Schicht aufgebracht werden, welche die Transmissionswellenlänge des Glasplättchens verschiebt. Um die gewünschte Wellenlänge, bei der die Transmission des Etalons am höchsten ist, genau einzustellen, wird während der Beschichtung die Transmission gemessen.

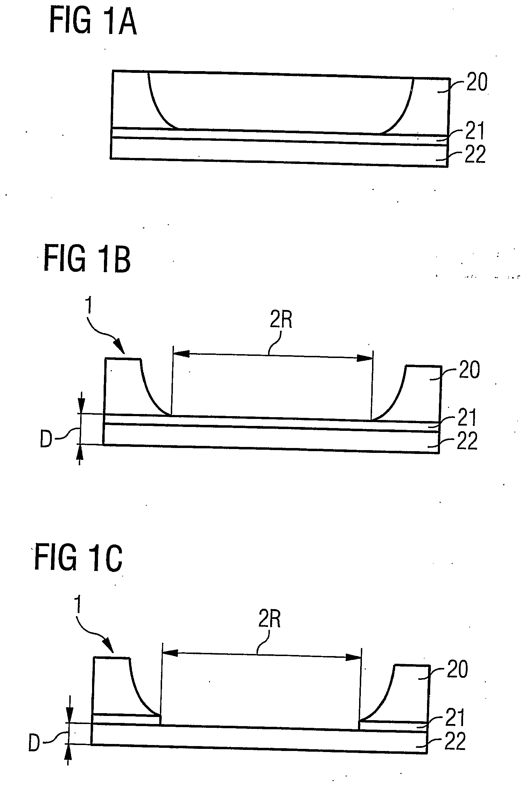

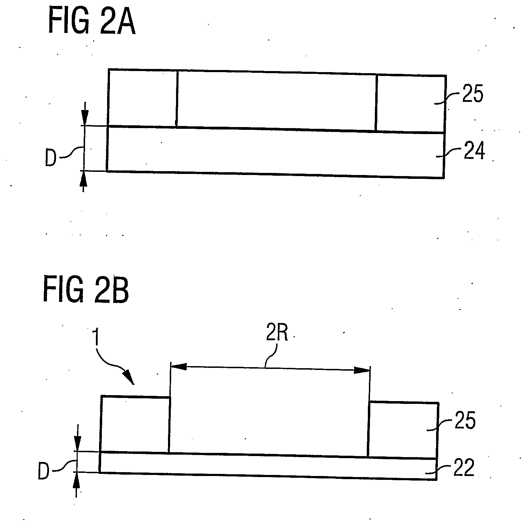

Im Folgenden wird die hier beschriebene optoelektronische Halbleitervorrichtung
anhand von Ausführungsbeispielen und den dazugehörigen Figuren näher erläutert.
In Verbindung mit den Figuren 1A bis 1C ist anhand schematischer Schnittdarstellungen ein Verfahren zur Herstellung eines beispielhaften Etalons beschrieben.
In Verbindung mit den Figuren 2A und 2B ist anhand schematischer Schnittdarstellungen ein Verfahren zur Herstellung eines erfindungsgemäßen Etalons beschrieben.
Die Figur 3 zeigt in einer schematischen Perspektivdarstellung ein Beispiel einer optoelektronischen Halbleitervorrichtung.
Die Figur 4 zeigt in einer schematischen Perspektivdarstellung ein Beispiel einer optoelektronischen Halbleitervorrichtung.
Die Figur 5 erläutert in einer schematischen Schnittdarstellung ein Beispiel einer optoelektronischen Halbleitervorrichtung.
Die Figur 6 erläutert in einer schematischen Schnittdarstellung ein Ausführungsbeispiel einer erfindungsgemäßen optoelektronischen Halbleitervorrichtung.
Die Figur 7 erläutert in einer schematischen Schnittdarstellung ein Beispiel einer optoelektronischen Halbleitervorrichtung.
Die Figur 8 erläutert in einer schematischen Schnittdarstellung ein Beispiel einer optoelektronischen Halbleitervorrichtung.
Die Figur 9 erläutert in einer schematischen Schnittdarstellung ein Beispiel einer optoelektronischen Halbleitervorrichtung.
In Verbindung mit den Figuren 10A und 10B ist anhand einer schematischen Perspektivdarstellung beziehungsweise einer schematischen Draufsicht ein Beispiel eines Etalons beschrieben.
In Verbindung mit den Figuren 11A, 11B und 11C ist in einer schematischen Schnittdarstellung sowie anhand grafischer Auftragungen ein Beispiel eines Etalons beschrieben.

In den Ausführungsbeispielen und Figuren sind gleiche oder gleich wirkende Bestandteile jeweils mit den gleichen Bezugszeichen versehen. Die dargestellten Elemente sind nicht als maßstabsgerecht anzusehen, vielmehr können einzelne Elemente zum besseren Verständnis übertrieben groß dargestellt sein.

Die Figur 1A zeigt eine Ausschnitt eines Aufwachssubstrats 20 - beispielsweise einen 100 Millimeter GaAs Wafer. Auf das Substrat 20 ist eine Ätzstoppschicht 21 epitaktisch abgeschieden. Die Ätzstoppschicht 21 ist beispielsweise aus GaInP gebildet. Auf die Ätzstoppschicht 21 ist eine Etalon-Schicht 22 epitaktisch abgeschieden. Die Etalon-Schicht 22 besteht beispielsweise aus GaAs.

In einem nachfolgenden Verfahrensschritt wird das Aufwachssubstrat 20 mittels einer Fototechnik strukturiert und bis zur Ätzstoppschicht 21 geätzt. Auf diese Weise entstehen auf einem einzigen Aufwachssubstrat mehrere Tausend Etalons 1. Bevorzugt weist die Etalon-Schicht 22 eine Dicke D zwischen wenigstens zwei und höchstens 50 Mikrometer auf. Besonders bevorzugt beträgt die Dicke der Etalon-Schicht 22 zwischen wenigstens 2 und höchstens 5 Mikrometer. Der Durchmesser der Etalons das heißt, der Durchmesser 2R der in das Aufwachssubstrat 20 geätzten Öffnung beträgt vorzugsweise zwischen 500 und 800 Mikrometer.

Wie in der schematischen Schnittdarstellung der Figur 1B dargestellt ist es möglich, dass das Etalon 1 neben der Etalon-Schicht 22 die Ätzstoppschicht 21 umfasst.

Wie in der schematischen Schnittdarstellung der Figur 1C gezeigt ist es weiterhin möglich, dass die Ätzstoppschicht nach dem Herstellen der Öffnung im Aufwachssubstrat 20 entfernt wird. Das Etalon 1 ist dann durch die epitaktisch abgeschiedene Etalon-Schicht 22 gebildet. Das Aufwachssubstrat 20 und die verbleibende Ätzstoppschicht 21 dienen als Träger für die Etalon-Schicht 22. Die Chipdicke, das heißt, die Dicke des Aufwachssubstrat 20 und der Etalon-Schicht 22 beträgt circa 100 Mikrometer.

In Verbindung mit den schematischen Schnittdarstellungen der Figuren 2A und 2B ist ein weiteres Ausführungsbeispiel eines Verfahrens zur Herstellung eines hier beschriebenen Etalons erläutert.

Gemäß diesem Ausführungsbeispiel wird - wie in der Schnittdarstellung der Figur 2A schematisch dargestellt - eine Etalon-Schicht 22, die durch eine Glasscheibe gebildet ist, auf einen Träger 25 gebondet, der durch eine Siliziumscheibe gebildet ist.

In einem nachfolgenden Verfahrensschritt wird die Dicke der Glasscheibe mittels Ätzen und/oder Schleifen und Polieren auf die gewünschte Dicke der Etalon-Schicht 22 reduziert. Der Träger 25 wird anschließend mit Hilfe einer Fototechnik strukturiert und stellenweise bis zur Etalon-Schicht 22 geätzt. Alternativ kann das stellenweise Entfernen des Siliziumträgers auch vor dem anodischen Bonden der Glasscheibe 24 auf den Siliziumträger 25 erfolgen.

Es resultiert ein Etalon 1 mit einer Etalon-Schicht 22 einer Dicke D zwischen vorzugsweise zwei und 50 Mikrometer und einem Durchmesser zwischen vorzugsweise 500 und 800 Mikrometer. Besonders bevorzugt beträgt die Dicke D der Etalon-Schicht zwischen wenigstens 20 Mikrometer und höchstens 30 Mikrometer. Die Chipdicke, das heißt die Dicke des verbleibenden Siliziumträgers und der Etalon-Schicht 22 beträgt circa 100 Mikrometer. Das Etalon 1 umfasst einen Träger 25 und eine Etalon-Schicht 22.

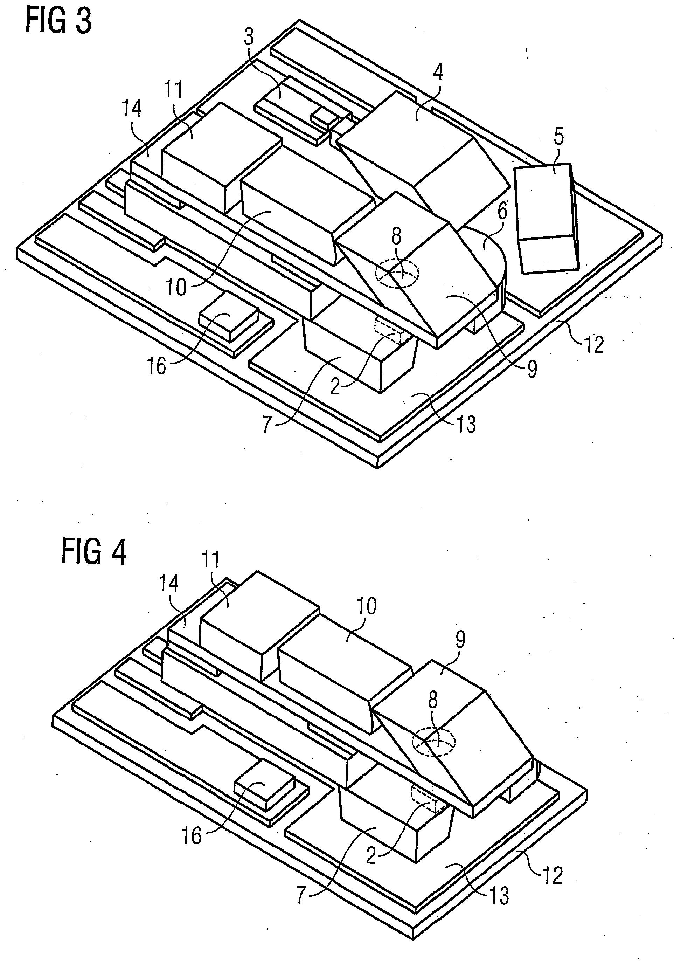

Die Figur 3 zeigt eine schematische Perspektivdarstellung eines ersten Ausführungsbeispiels einer hier beschriebenen optoelektronischen Halbleitervorrichtung. Bei der optoelektronischen Halbleitervorrichtung handelt es sich um eine optoelektronische Halbleiterlaservorrichtung.

Die optoelektronische Halbleitervorrichtung umfasst einen oberflächenemittierenden Halbleiterchip 2. Bei dem oberflächenemittierenden Halbleiterchip 2 handelt es sich um einen optoelektronischen Halbleiterchip, der mittels einer Pumpstrahlung optisch gepumpt wird. Die Pumpstrahlung für den optoelektronischen Halbleiterchip 2 wird von der Pumpstrahlquelle 3 erzeugt.

Bei der Pumpstrahlquelle 3 handelt es sich beispielsweise um einen kantenemittierenden Halbleiter-Dioden-Laser. Die von der Pumpstrahlquelle 3 erzeugte Pumpstrahlung durchläuft zunächst ein optisch brechendes optisches Element, das geeignet ist, durch optische Brechung die Pumpstrahlung anzuheben, das heißt, um einen gewissen Betrag parallel zu verschieben. Bei dem optisch brechenden optischen Element 4 handelt es sich beispielsweise um ein Parallelelepiped.

Die Pumpstrahlung trifft nachfolgend auf einen Umlenkspiegel 5, der die Pumpstrahlung auf eine asphärische Zylinderlinse 6 richtet. Von der asphärischen Zylinderlinse 6 trifft die Pumpstrahlung auf eine Umlenkoptik 7, die die Pumpstrahlung auf eine Strahlungsdurchtrittsfläche 2a des optoelektronischen Halbleiterchips 2 richtet.

Im optoelektronischen Halbleiterchip 2 verstärkte elektromagnetische Strahlung 32 tritt durch eine Ausnehmung 8 im Träger 14. Der Träger 14 stellt einen Träger für den zweiten Resonatorspiegel 11 sowie für weitere optische Komponenten dar. Die elektromagnetische Strahlung 32 trifft zunächst auf ein Umlenkelement 9 das beispielsweise durch ein Parallelelepiped gebildet ist, das zur Strahlumlenkung und Auskopplung vorgesehen ist. Die elektromagnetische Strahlung 32 durchläuft einen optisch nicht-linearen Kristall 10, der beispielsweise zur Frequenzverdoppelung geeignet ist. Der frequenzverdoppelte Anteil der elektromagnetischen Strahlung wird durch das Umlenkelement 9 aus der Halbleitervorrichtung ausgekoppelt. Beispielsweise ist die Halbleitervorrichtung zur Erzeugung von Laserstrahlung im grünen Spektralbereich geeignet.

Die Komponenten der optoelektronischen Halbleitervorrichtung sind auf einem Träger aufgebracht, der einen Grundkörper 12 umfasst. Der Grundkörper 12 ist zum Beispiel aus einem keramischen Material wie Aluminiumnitrid gebildet. Auf die Oberseite des Grundkörpers 12 ist eine strukturierte Oberseitenmetallisierung 13 aufgebracht, die beispielsweise Leiterbahnen bildet. Die Oberseitenmetallisierung 13 ist beispielsweise durch eine Goldschicht gegeben.

Die Halbleitervorrichtung weist ferner einen Temperatursensor 16 auf, der beispielsweise einen NTC-Widerstand umfasst. Mittels des Temperatursensors 16 kann die mittlere Temperatur der Halbleitervorrichtung ermittelt werden. Abhängig von der mittleren Temperatur kann beispielsweise mit Hilfe eines thermoelektrischen Kühlers, der etwa an der Unterseite des Grundkörpers 12 angeordnet ist, eine Betriebstemperatur der Pumpstrahlquelle 3 eingestellt werden.

In Verbindung mit der Figur 4 ist anhand einer schematischen Perspektivdarstellung ein weiteres Ausführungsbeispiel einer hier beschriebenen optoelektronischen Halbleitervorrichtung erläutert. Im Unterschied zum Ausführungsbeispiel, das in Verbindung mit der Figur 3 beschrieben ist, weist die Halbleitervorrichtung der Figur 4 einen optoelektronischen Halbleiterchip 2 auf, der geeignet ist, ohne externe Pumpquelle elektromagnetische Strahlung 32 zu erzeugen, die im Resonator der Halbleitervorrichtung umläuft. Beispielsweise kann es sich bei dem optoelektronischen Halbleiterchip 2 um einen elektrisch gepumpten Halbleiterlaserchip handeln. Darüber hinaus ist es möglich, dass es sich bei dem optoelektronischen Halbleiterchip 2 um einen optisch gepumpten Halbleiterchip handelt, bei dem die Pumpstrahlquelle monolithisch integriert ist.

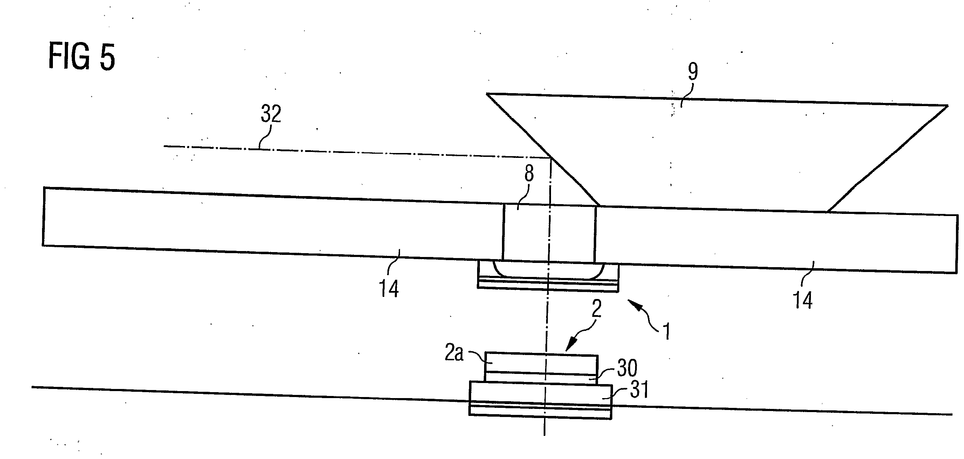

Die Figur 5 zeigt eine schematische Schnittdarstellung einer hier beschriebenen optoelektronischen Halbleitervorrichtung gemäß einem weiteren Beispiel. In diesem Beispiel ist ein Etalon wie es in Verbindung mit den Figuren 1B, 1C oder 2B beschrieben ist im Resonator der Halbleitervorrichtung angeordnet. Das Etalon 1 ist dabei auf den Träger 14 für den zweiten Resonatorspiegel 11 aufgebracht, beispielsweise aufgeklebt.

Der Einfachheit halber ist das Etalon in den Figuren stets in senkrechter Einbaulage, das heißt, mit einem Einfallswinkel von 0° gezeigt. Es ist jedoch möglich, dass das Etalon mit einem Einfallswinkel zwischen 0° und 30° insbesondere mit einem Einfallswinkel zwischen 0° und 20° eingesetzt wird. Der zweite Resonatorspiegel ist durch eine reflektierende Schichtenfolge 30, beispielsweise eine Bragg-Spiegel, des Halbleiterchips 2 gebildet. Der Halbleiterchip 2 ist mit seiner der Strahlungsdurchtrittsfläche 2a abgewandten Seite auf einen Kühlkörper 31 aufgebracht. Das Etalon 1 ist dabei derart auf den Träger 14 positioniert, dass es die Ausnehmung 8 im Träger 14 überdeckt.

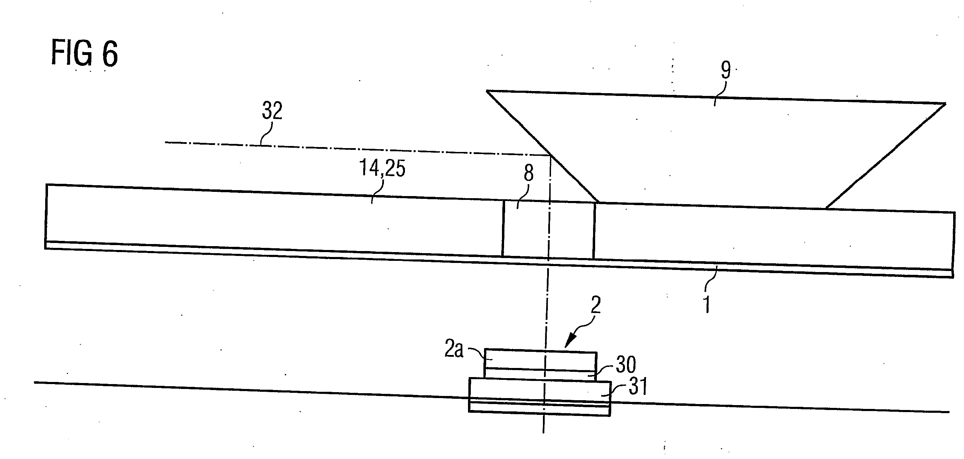

Figur 6 zeigt eine schematische Schnittdarstellung eines Ausführungsbeispiels einer hier beschriebenen optoelektronischen Halbleitervorrichtung. In diesem Ausführungsbeispiel ist das Etalon 1 wie in Verbindung mit der Figur 2B dargestellt, ausgeführt. Das heißt, das Etalon 1 ist durch eine Glasscheibe gebildet, die die Etalon-Schicht 22 bildet, welche flächig anodisch auf einen Siliziumträger 25 gebondet ist. Der Siliziumträger 25 bildet einen Träger der Etalon-Schicht 22 und zugleich einen Träger 14 für den zweiten Resonatorspiegel 11.

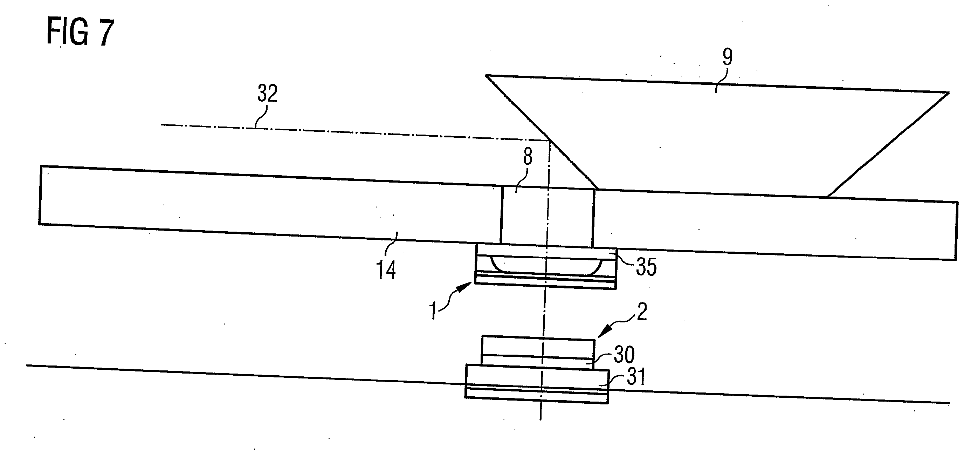

In Verbindung mit der Figur 7 ist anhand einer schematischen Schnittdarstellung ein weiteres Beispiel einer hier beschriebenen optoelektronischen Halbleitervorrichtung erläutert. Im Unterschied zum Ausführungsbeispiel der Figur 5 ist in diesem Beispiel zwischen dem ersten Etalon 1 und dem Träger 14 ein dickes Etalon 35 angeordnet. Das dicke Etalon 35 erlaubt in Kombination mit dem dünneren, ersten Etalon einen Einzel-Frequenz-Laser. Das erste Etalon 1 und das dicke Etalon 35 sind beispielsweise miteinander verklebt. Der derart erzeugte Stapel von Etalons ist wiederum auf den Träger 14 geklebt oder gebondet.

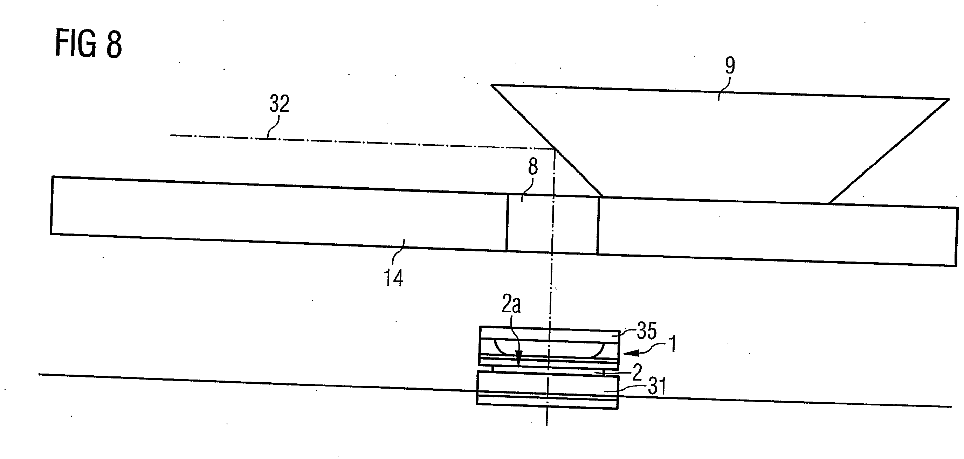

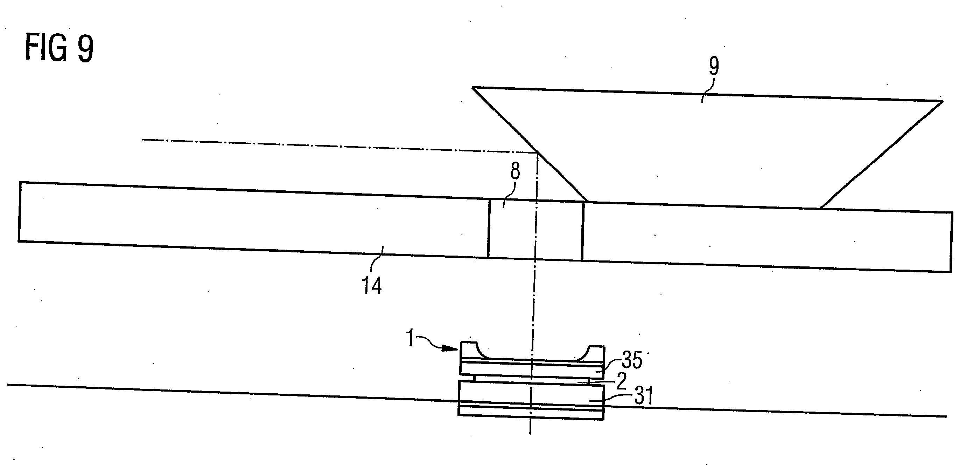

In Verbindung mit der Figur 8 ist anhand einer schematischen Schnittdarstellung ein weiteres Beispiel einer hier beschriebenen optoelektronischen Halbleitervorrichtung erläutert. In diesem Beispiel ist im Unterschied zum Beispiel der Figur 7 ein Stapel aus einem ersten, dünneren Etalon 1 und einem zweiten, dickeren Etalon 35 direkt auf die Strahlungsdurchtrittsfläche 2a des Halbleiterchips 2 aufgebracht, beispielsweise aufgeklebt. Die Figur 9 zeigt in einer schematischen Schnittdarstellung ein weiteres Beispiel einer hier beschriebenen optoelektronischen Halbleitervorrichtung. Im Gegensatz zum Beispiel der Figur 9 ist in diesem Beispiel auf das weitere, dickere Etalon 35 verzichtet.

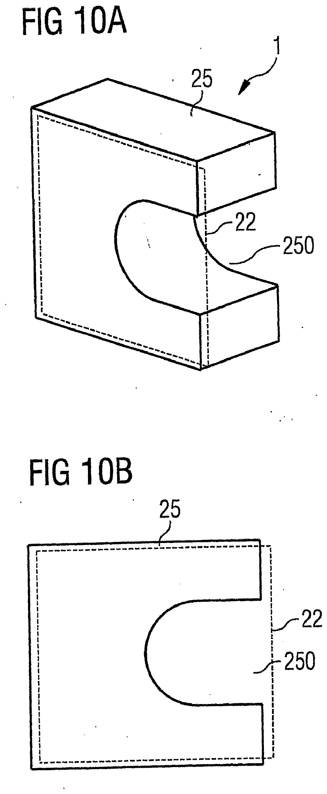

Die Figur 10A zeigt in einer schematischen Perspektivdarstellung ein Ausführungsbeispiel eines hier beschriebenen Etalons 1. Das Etalon 1 umfasst einen Träger 25, der beispielsweise aus Silizium oder Glas besteht. Auf den Träger 25 ist eine Etalon-Schicht 22 befestigt. Die Etalon-Schicht 22 besteht vorzugsweise aus einem Glas, beispielsweise aus einem Floatglas. Die Etalon-Schicht 22 kann mittels anodischem Bonden oder Kleben am Träger 25 befestigt sein. Der Träger 25 weist eine Ausnehmung 250 auf. Die Ausnehmung 250 kann vor und nach dem Befestigen der Etalon-Schicht 22 am Träger 25 erzeugt werden. Die Ausnehmung 250 ist an einer Stelle im Träger 25 vorgesehen, an der elektromagnetische Strahlung, die von der Etalon-Schicht 22 frequenzselektiert werden soll, durch die Etalon-Schicht 22 tritt.

Wie insbesondere auch aus der schematischen Draufsicht in Figur 10B ersichtlich ist, kann die Ausnehmung 250 beispielsweise U-förmig ausgebildet sein.

Die Dicke der Etalon-Schicht 22 beträgt vorzugsweise zwischen 40 und 50 µm, insbesondere 30 µm. Der Träger 25 und die Etalon-Schicht 22 weisen in Summe eine konstante Dicke von vorzugsweise höchsten 1 mm und maximal 1,5 mm auf. Eine solche Dicke des Trägers 25 sorgt für eine ausreichende mechanische Stabilität des Etalons 1.

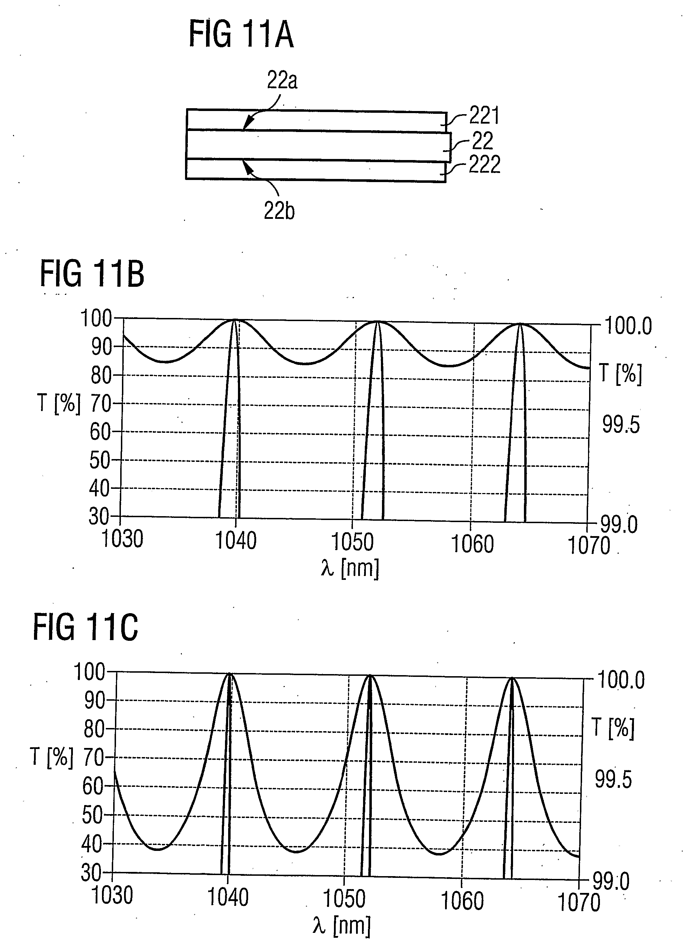

Die Figur 11A zeigt eine schematische Schnittdarstellung eines weiteren Beispiel eines Etalons 1. In der Figur 11A ist dabei lediglich die Etalon-Schicht 22 gezeigt. Auf die Darstellung eines Trägers ist aus Gründen der Übersichtlichkeit in Figur 11A verzichtet. Die Etalon-Schicht 22 ist wie in einem der hier beschriebenen Ausführungsformen und Ausführungsbeispielen gebildet. Das heißt, die Etalon-Schicht 22 besteht aus Glas oder einem Halbleitermaterial. Die Etalon-Schicht 22 weist zwei Strahlungsdurchtrittsflächen 22a und 22b auf, die für den Durchtritt von elektromagnetischer Strahlung vorgesehen sind. Die Strahlungsdurchtrittsflächen 22a und 22b sind mit dielektrischen Schichten 221 und 222 beschichtet. Vorzugsweise bestehen die dielektrischen Schichten 221, 222 aus einem dielektrischen Material, das einen größeren Brechungsindex als die Etalon-Schicht 22 aufweist.

Die dielektrischen Schichten 221 und 222 sind vorzugsweise identisch aufgebaut. Das heißt, die dielektrischen Schichten 221 und 222 bestehen aus demselben dielektrischen Material und weisen eine gleiche, gleichmäßige Dicke auf.

Es hat sich gezeigt, dass die dielektrischen Schichten 221 und 222 die Transmissionscharakteristik des Etalons 1 verbessern. Handelt es sich bei der Etalon-Schicht 22 beispielsweise um eine Etalon-Schicht, die aus Glas mit einer Dicke von cirka 30 µm besteht, so ergibt sich für das Etalon 1 die in Figur 1B gezeigte Transmissionscharakteristik. Dabei ist am linken und am rechten Rand die Transmitivität in Prozenten aufgetragen. Die Transmitivität ist dabei in Abhängigkeit von der Wellenlänge λ der durch die Etalon-Schicht 22 tretenden elektromagnetischen Strahlung angegeben.

Die Figur 11C zeigt die Transmissionscharakteristik für das gleiche Etalon, das heißt, für eine Etalon-Schicht 22, die aus Glas mit einer Dicke von cirka 30 µm besteht, wobei auf beide Strahlungsdurchtrittsflächen 22a, 22b entsprechend der Figur 11A jeweils eine dielektrische Schicht 221, 222 aufgebracht ist. Bei der dielektrischen Schicht handelt es sich dabei um eine Schicht aus TaO₅, die eine Dicke von cirka 125 nm aufweist. Wie aus der Figur 11C im Vergleich mit der Figur 11B ersichtlich ist, verbessert die dielektrische Schicht die Transmissionscharakteristik des Etalons dahingehend, dass der Unterschied in der Transmitivität zwischen Wellenlängen, in denen das Etalon gut transmittiert und Wellenlängen, in denen das Etalon schlecht transmittiert, größer wird. Weiter verringert sich die Bandbreite des Etalons aufgrund der Beschichtung mit den dielektrischen Schichten 221, 222.

## Patentansprüche

1. Optoelektronische Halbleitervorrichtung mit
- einem oberflächenemittierenden Halbleiterchip (2),
- einem ersten (30) und einem zweiten Resonatorspiegel (11), die einen Resonator (30, 11) für die im Betrieb der Halbleitervorrichtung vom oberflächenemittierenden Halbleiterchip (2) erzeugte elektromagnetische Strahlung (32) bilden, und
- einem ersten Etalon (1), das als frequenzselektives Element für die vom oberflächenemittierenden Halbleiterchip erzeugte elektromagnetische Strahlung im Resonator (30, 11) angeordnet ist, wobei das erste Etalon (1) eine Etalon-Schicht (22) umfasst, **dadurch gekennzeichnet, dass**
- das erste Etalon (1) einen Träger (14, 25) und die Etalon-Schicht (22) umfasst, wobei der Träger (14, 25) einen Träger der Etalon-Schicht (22) und zugleich einen Träger (14, 25) für den zweiten Resonatorspiegel (11) bildet, und der Träger (14, 25) eine Ausnehmung (8) aufweist, wobei die elektromagnetische Strahlung (32) durch die Ausnehmung (8) tritt und zunächst auf ein Umlenkelement (9) trifft,
- die Etalon-Schicht (22) durch eine Glasscheibe gebildet ist, die den Träger (14, 25) flächig bedeckt und die die Ausnehmung (8) überdeckt, und
- der Träger (14, 25) ein Siliziumträger ist.

2. Optoelektronische Halbleitervorrichtung gemäß Anspruch 1 mit
zumindest einem optisch nicht-linearen Kristall (10), der im Resonator (30,11) angeordnet ist.

## Claims

1. Optoelectronic semiconductor device with
- a surface emitting semiconductor chip (2),
- a first (30) and a second resonator mirror (11) forming a resonator (30, 11) for the electromagnetic radiation (32) generated by the surface emitting semiconductor chip (2) during operation of the semiconductor device, and
- a first etalon (1) disposed in the resonator (30, 11) as a frequency selective element for electromagnetic radiation generated by the surface emitting semiconductor chip, the first etalon (1) comprising an etalon layer (22), **characterized in that**
- the first etalon (1) comprises a carrier (14, 25) and the etalon layer (22), the carrier (14, 25) forming a carrier of the etalon layer (22) and at the same time a carrier (14, 25) for the second resonator mirror (11), and the carrier (14, 25) having a recess (8), the electromagnetic radiation (32) passing through the recess (8) and initially impinging on a deflecting element (9),
- the etalon layer (22) is formed by a glass pane which covers the surface of the support (14, 25) and which covers the recess (8), and
- the carrier (14, 25) is a silicon carrier.

2. Optoelectronic semiconductor device according to claim 1 having
at least one optically non-linear crystal (10) disposed in said resonator (30,11).

## Revendications

1. Dispositif optoélectronique semi-conducteur avec
- une puce semi-conductrice à émission de surface (2),
- un premier (30) et un second miroir résonateur (11) formant un résonateur (30, 11) pour le rayonnement électromagnétique (32) généré par la puce semi-conductrice à émission de surface (2) pendant le fonctionnement du dispositif semi-conducteur, et
- un premier étalon (1) disposé dans le résonateur (30, 11) en tant qu'élément sélectif en fréquence pour le rayonnement électromagnétique généré par la puce semi-conductrice à émission de surface, le premier étalon (1) comprenant une couche d'étalon (22), **caractérisé en ce que**
- le premier étalon (1) comprend un support (14, 25) et la couche d'étalon (22), le support (14, 25) formant un support pour la couche d'étalon (22) et en même temps un support (14, 25) pour le deuxième miroir résonateur (11), et le support (14, 25) présente un évidement (8), le rayonnement électromagnétique (32) traversant l'évidement (8) et touchant initialement un élément déflecteur (9),
- la couche d'étalon (22) est formée par une vitre de verre qui couvre la surface du support (14, 25) et recouvre l'évidement (8), et
- le support (14, 25) est un support en silicium.

2. Dispositif optoélectronique semi-conducteur selon la revendication 1 avec
au moins un cristal optiquement non linéaire (10) disposé dans le résonateur (30, 11).
